# EUROPEAN PATENT SPECIFICATION

(11) **EP 1 521 868 B1**
(45) Date of publication and mention of the grant of the patent: **03.09.2008**
(21) Application number: 03763688.3
(22) Date of filing: 02.07.2003
(51) Int. Cl.: C25D 21/14

(54) **DEVICE AND METHOD FOR MONITORING AN ELECTROLYTIC PROCESS**
VORRICHTUNG UND VERFAHREN ZUR ÜBERWACHUNG EINES ELEKTROLYTISCHEN VERFAHRENS
DISPOSITIF PERMETTANT DE CONTROLER UN PROCESSUS ELECTROLYTIQUE ET METHODE AFFERENTE

(30) Priority: 12.07.2002 DE 10232612
(43) Date of publication of application: 13.04.2005
(73) Proprietor: ATOTECH Deutschland GmbH, 10553 Berlin (DE)
(72) Inventor: THIES, Andreas, 14167 Berlin (DE); DRETSCHKOW, Thomas, 12207 Berlin (DE)
(74) Representative: Patentanwälte Bressel und Partner
(86) International application number: PCT/EP2003/007051
(87) International publication number: WO 2004/007811

(56) References cited:
- GB-A- 871 203
- US-B1- 6 261 433
- PATENT ABSTRACTS OF JAPAN vol. 2003, no. 03, 5 May 2003 (2003-05-05) & JP 2002 322592 A (HITACHI LTD), 8 November 2002 (2002-11-08)

## Description

The invention relates to a device and a method for monitoring an electrolytic process, more specifically for electrolytically depositing metal onto a substrate.

Integrated circuits on wafers, more specifically made from silicon, are manufactured generally using etching and deposition processes in conjunction with photolithographic processes. Up to the present, metallic conductive patterns have been customarily produced using sputter processes for establishing electrical conductor connections on the wafers. For some years galvanic processes have been increasingly utilized to manufacture integrated circuits on wafers. Aside from the electrolytic deposition of copper in what is termed the "back end" portion, i.e., for wiring the semiconductor structures produced on the wafer, the metal deposition of copper, nickel, gold and tin in what is termed the "packaging" process i.e., when metal is deposited onto chip carriers, and in rewiring becomes increasingly important. All these requirements have in common that an electrolytic metal deposition process is initiated on a thin starting metal layer, the so-called seed layer, also termed plating base. For this purpose, the starting layer is placed in electric contact using suited mechanical contacts and is placed in an electroplating bath containing the metal to be deposited in solution. Current is caused to flow through the starting layer and the counter electrode using an external current source, for example of a rectifier energized by the electric network, and a counter electrode so that metal is deposited onto the starting layer of the wafer. The amount and, as a result thereof, the coating thickness of the deposited metal is controlled through Faraday's law.

Coating thickness distribution on the wafer may be positively affected using suited shields or segmented anodes (counter electrodes). Soluble anodes are thereby used to keep the metal ion concentration in the electrolyte fluid constant or, alternatively, insoluble (inert) anodes, in which case the metal ion content must be kept constant, making additional provisions.

U.S. Patent No. 5,234,572 A describes a method for replenishing metal ions to a plating bath. To control the quantity of electricity transmitted between cathode and anode when current is applied, U.S. Patent No. 5,234,572 A suggests a measuring arrangement that measures the potential of the cathode (counter electrode) using a reference electrode additionally placed in the plating bath and made of the same metal as the anode. The quantity of electricity conducted is controlled such that the measured potential of the counter electrode may not be negative with respect to said reference electrode. This prevents metal ions from depositing on the counter electrode. In a preferred exemplary embodiment, the counter electrode and a soluble electrode (anode) are connected to a DC supply. A voltmeter is used for measuring the potential of the counter electrode relative to the reference electrode. The potentials at the counter electrode and at the soluble electrode, which vary with the current flow, are shown in a figure.

In case of electrolytic copper depostion, DE 199 15 146 C1 mentions that the copper depostion bath contains, in addition to the usual bath constituents, Fe(III) compounds for example and that these compounds cause the copper pieces to dissolve to form copper ions, yielding Fe(II) compounds in the process. The Fe(II) compounds formed are reoxidized to Fe(III) compounds at the insoluble anodes.

All of the known electroplating baths contain, in addition to the metal ions to be deposited, auxiliary agents for influencing the metal deposition. As a rule, these agents are organic compounds for influencing the structure of the deposited layer on the one side and salts, acids or bases that are added for the purpose of stabilizing the bath and of increasing the electric conductivity thereof on the other side. The voltage required for deposition is reduced as a result thereof, thus generating a minimum of Joule heat. This increases the safety of the process. Certain processes are only made possible by adding these agents.

Generally, conductive patterns are presently produced according to the damascene process. As recited in DE 199 15 146 C1, a dielectric layer is first applied on the semiconductor substrate for this purpose. The vias and trenches required for receiving the desired conductive pattern are etched in the dielectric layer, usually using a dry etch process. After a diffusion barrier (in most cases tantalum nitride, tantalum) and a conductive layer (in most cases sputtered copper) are applied, the depressions, i.e., the vias and trenches, are electrolytically filled using the "trench filling process". As copper is deposited on the entire surface, the excess must be subsequently removed from the unwanted locations, meaning from the zones outside the vias and trenches. This is achieved using what is termed the CMP process (Chemical Mechanical Polishing). Multilayer circuits can be made by reiterating the process i.e., by repeatedly applying the dielectric, made from silicon dioxide for example, forming the depressions by etching and depositing copper.

After the conductive pattern, more specifically made from copper, is made, it can be found out, in the polished sections intended for control, that metal defects (voids) readily form in the deposited structures, said defects possibly leading to a functional breakdown of the entire circuit.

Therefore the problem the present invention is facing is to avoid the drawbacks of the known devices and methods and more specifically to find measures permitting to reliably prevent such defects from forming.

In overcoming this problem the invention provides the device according to claim 1 and the method according to claim 6. Preferred embodiments of the invention are indicated in the subordinate claims.

The device according to the invention serves to monitor an electrolytic process, more specifically the electrolytic metal deposition process, during manufacturing of integrated circuits of semiconductor substrates (wafers) and of circuit structures on chip carriers.

To explain the invention in closer detail, the term "wafer" will be used herein after to designate a wafer or chip carrier substrate. Likewise, the terms "deposition electrolyte" or "deposition electrolyte fluid" will be used to refer to the electrolyte fluid used for carrying out the electrolytic process. Alternatively, said fluid could also be an etch fluid if the electrolytic process is an electrolytic etch process. Possible electrolytic processes are both electrolytic deposition methods and electrolytic' metal etching methods. In principle, the invention can also be utilized for other electrolytic processes than those mentioned herein. In the following description, the term "electrolytic deposition process" will be used to refer to all the other electrolytic processes as well.

In overcoming the problem, the invention provides a device and a method. The device is comprised of at least one anode and of at least one cathode that are in contact with an electrolyte fluid, an electric current flow being generated between them. At least one first reference electrode is disposed at (near) the surface of the at least one anode and at least one second reference electrode is disposed at (near) the surface of the at least one cathode. At least one voltmeter for determining the respective electric voltages between the at least one anode and the at least one first reference electrode, between the at least one first and the at least one second reference electrode and between the at least one second reference electrode and the at least one cathode is further provided in accordance with the invention. This arrangement permits to simultaneously register electrolytic partial processes at the various electrodes, this very provision permitting to also measure time-variant processes. It thereby makes no matter whether the electrodes are only immersed into the electrolyte fluid during measurement or whether a voltage is applied between cathode and anode only when the two electrodes are contacting the electrolyte fluid.

The cathode is a wafer or a chip carrier substrate and, in a preferred application of the device in accordance with the invention. the anode a metal plate. In this case, preferably metal is deposited onto the wafer or the chip carrier substrate during the electrolytic process.

Hence, the device in accordance with the invention is comprised of at least one first reference electrode which is disposed at (near) the surface of the at least one anode, and of at least one second reference electrode which is disposed at (near) the surface of the at least one cathode. Here specifically, voltmeters for measuring the electric voltages between the at least one anode and the at least one first reference electrode, between the at least one first and the at least one second reference electrode and between the at least one second reference electrode and the at least one cathode are further provided. This monitoring device serves to measure the electric voltages between the anode and the first reference electrode, between the first reference electrode and the second reference electrode and between the second reference electrode and the cathode.

Comprehensive tests showed that the defects (e.g. voids) in the deposited metal layers are due to the fact that the metal deposition baths used are capable, under certain conditions, of removing metal from the starting layers:

When a wafer provided with a starting metal layer is immersed in the metal deposition solution, no external voltage is applied to the starting layer at first. Accordingly, an equilibrium potential is achieved at the phase boundary between the starting layer and the electrolyte solution as soon as the two are coming into contact. Under the usual conditions applied for depositing metal, more specifically copper, onto the starting layer, the potential of the starting layer relative to the metal dissolution is positive so that said starting layer slowly dissolves in the deposition solution.

Metal starting layers which are utilized on wafers are generally very thin for reasons related to cost and process. For example, in typical structures (trenches, vias of e.g., 0.1 - 0.2 µm wide and about 1 µm deep) made for the damascene process, the starting layers usually are from about 5 - 25 nm thick. By contrast, the starting layers on the surfaces of the wafers are about 100 nm thick. Such type layers can be quickly removed, at least within the structures, during immersion in the electrolyte solution since the etch rate in the electrolyte solutions used is quite high. In a typical copper electrolyte containing about 180 g/l sulfuric acid and 40 g/l copper in the form of copper sulfate, the etch rate is about 10 nm/min under usual electrolysis conditions. Under these conditions, the coating thickness that remains prior to metal deposition may, under certain circumstances, not suffice to ensure reliable metal coating. The etch rate depends, inter alia, on the type of electrolyte solution used, the conditions chosen for the deposition process and the type of starting layer.

This problem cannot be overcome by shortening the time between immersion and the start of the deposition process since a certain minimum processing time must be observed after immersion in order for example to completely wet the wafer to be coated with fluid prior to starting metal deposition. Accordingly, the time window available for the process of electrolytically depositing metal onto the starting layer is but a narrow one. A particular problem is that, due to the plurality of possible influencing variables, the size of the time window for the process cannot be determined so that the result of metallization is left to chance only.

The thin starting metal layer is particularly sensitive to fluctuations of the deposition process and to corrosion. The slightest reduction in the thickness of this layer may suffice to jeopardize the safe start of the process in the nanostructures for example.

It is therefore very important to precisely control the immersion and wetting procedures. Technically, such a control is not readily possible because of the lack of electrical contact between the electrolyte fluid and the wafer prior to immersion and of the electrolyte dependent equilibrium potential obtained after immersion. Depending on the electrolyte composition, the starting layer may corrode to a greater or lesser, unforeseeable extent.

It has been found that the parameters that more specifically influence the metal removal are the partial voltages which, summed, yield the total electric voltage (clamp voltage) applied between anode and cathode:

During electrolytic metal deposition, a current flows between anode and cathode. An electric voltage composed of the sum of the partial voltages mentioned is needed to generate said current flow. The total voltage is more specifically the result of the sum of anodic and cathodic charge transfer overvoltage, polarization overvoltages and crystallization overvoltages and also of concentration overvoltages and of the voltage drop due to the electrolyte resistance and the voltage drops in the electrical feed lines.

As a rule, it is not known how the measurable clamp voltage distributes between the individual voltages. More specifically, variations in the distribution cannot be registered as only the clamp voltage of the current source e.g., of the rectifier is known. If, during deposition, one of the resistances mentioned or one of the overvoltages listed varies or if they fluctuate between various wafers to be processed, it will, at the best, not be possible to interpret the resulting measurable change of the clamp voltage. At the worst, this change will not even be noted so that metal will possibly be removed with no possibility to find out about it.

As in the semiconductor technology the process safety and the reproducibility of the methods are of prime importance, means had to be found to register the partial voltages. Variations during the process must be interpreted and identified in order to permit control and correction of the process.

In order to at least detect variations in the voltage drop that are due to the electric resistance of the electrolyte, reference electrodes are utilized, which are disposed directly on the surface of the anode or cathode. For this purpose, the reference electrodes are to be brought so close to the surfaces that the potential can be measured directly at the respective one of the surfaces. The reference electrodes can for example be brought so close to the respective one of the surfaces that the spacing therefrom is less than 1 mm, for example 0.2 mm. More specifically, the reference electrodes may also be arranged for example in the plane of the anode's or cathode's surface beside the surface, but in immediate proximity thereto, although not directly in front of said surface. The reference electrodes thereby need not be brought to contact the surfaces. Another possibility consists in placing a small container containing a conductive electrolyte on the respective surface or in proximity thereto, the reference electrode in said container permitting to detect the potential at the surface.

In a preferred embodiment of the invention, two reference electrodes are provided: the first of the two reference electrodes is arranged at the surface of the anode and the second reference electrode at the surface of the cathode. As the two reference electrodes are disposed in immediate proximity to the respective one of the electrodes, the influence of the voltage drop due to the electric resistance of the electrolyte can be detected separately in the form of the electric voltage between the two reference electrodes. The other voltage drops measured between a respective one of the reference electrodes and the anode or cathode at the surface of which said electrodes are disposed include the voltage drops occurring in proximity to the anode or cathode surface and more specifically the charge transfer, crystallization and concentration overvoltages.

The various voltage drops in different regions of the electrolytic cell can thus be detected and, as a result thereof, the influence of the afore mentioned factors (such as the type of the electrolyte solution, the properties of the starting layer and others) can be detected separately and analyzed accordingly. Variations due to the influencing variables mentioned may thus be identified so that appropriate provisions can be made in the event of such changes.

An advantage of the invention is that existing electroplating plants can be readily retrofitted with the means of the invention since no substantial structural extension is needed.

Any reference electrode can be utilized to measure the variations mentioned Stable reference electrodes more specifically contain a metal that is in equilibrium with a hardly soluble salt of said metal and an electrolyte. Such type reference electrodes are for example electrodes of the second or third order since these electrodes provide a constant reference potential. Reference electrodes of the second order are reference electrodes in which the concentration of the potential-determining ions is determined by the presence of a hardly soluble compound the ions of which are the same as the potential-determining ions. Reference electrodes of the third order, by contrast, are reference electrodes in which the activity of the potential-determining ions is determined by the presence of two solid phases. Reference electrodes of the second order are more specifically the calomel electrode, the silver/silver chloride electrode, the mercuric sulfate electrode and the mercuric oxide electrode. Reference electrodes of the third order may for example be a zinc rod that is in equilibrium with a solution of calcium ions in the presence of a precipitate made from zinc and calcium oxalate.

One reference electrode is mounted in proximity to the anode, another in proximity to the wafer. The process is controlled by measuring the voltage between the anode and the first reference electrode, between the first reference electrode and the second reference electrode and between the second reference electrode and the cathode during the electrolytic process.

The voltage measured between the first reference electrode and the second reference electrode is the result of variations of the electrolyte resistance which are indicative of the unstable composition of the electrolyte or of the irregular fluid flow within the processing tank.

Variations of the voltage measured between the first reference electrode and the anode are additionally indicative of an unstable anode process. With a soluble anode being used, this may be due to the consumption of the anode, to a change in the anode film or to a varying anode geometry. With an inert (insoluble) anode, such a change in the measured voltage may also be indicative of a failure of this anode (the active anode layer may for example peel off) or of poor redox species, e.g., Fe(II) and Fe(III) compounds, supply to the anode, for example in the event the method described in DE 100 15 146 C1 is performed.

Variations of the voltage measured between the second reference electrode and the cathode are indicative of an unstable cathode process such as an altered thickness of the starting layer, for example because this layer is attacked by the metal deposition solution or because the layer has never been thick enough.

To control the process, more specifically to prevent the starting layer from corroding, a voltage difference between the starting layer and the nearest reference electrode, the second reference electrode for example, can be applied by a power rectifier prior to immersion. The proper choice of the potential of the starting layer permits to prevent it from corroding during immersion and possibly in the wetting phase as well. In order to obtain a useful result of the measurement, the respective one of the reference electrodes must be brought as close as possible to the associated electrode. However, the workpiece (the cathode for example) and the counter electrode (the anode for example) must thereby be prevented from being unshielded in order for the deposited metal to be distributed as uniformly as possible.

As stable reference electrodes more specifically contain a metal that is in equilibrium with a hardly soluble salt of said metal and an electrolyte, there is a risk that the electrolyte of the electrolytic process be contaminated by the electrolyte of the reference electrode. Such a contamination has to be prevented by all means. In order to overcome this problem as well, the reference electrodes contact the surface of the anode or of the cathode through at least one capillary. In that the measurement of the voltages between the reference electrodes and between a respective one of the reference electrodes and the anode and cathode, respectively, is a high resistance measurement, but a very little current flows through the measuring arrangement. As a result, the capillary can be very thin so that contamination of the electrolyte of the electrolytic process through the electrolytes of the reference electrodes is minimized.

Another improvement with regard to this problem is achieved in that electrolyte fluid of the electrolytic process is supplied to the respective one of the reference electrodes via the capillaries. The electrolyte of the reference electrode is thus prevented from entering by diffusion into the deposition electrolyte.

To electrolytically deposit metal, more specifically copper, onto a semiconductor substrate, customary electroplating arrangements, made from platinum for example, can be utilized in which the anode and the semiconductor substrate are paralleled and oriented horizontally or tilted from horizontal. The anode and the semiconductor substrate can also be oriented vertically. The two electrodes are located in a tank configured to suit the purpose, a cylindrical tank for example, which accommodates the electrolyte fluid and the electrodes. Usually, the anode is disposed on the bottom of the cylindrical tank and the semiconductor substrate in the upper portion thereof. To generate a defined fluid flow, the electrolyte fluid can flow through the tank in a certain manner. The reference electrodes may be housed in separate containers communicating with the cylindrical tank via the capillaries mentioned. The capillaries are disposed in the wall of the tank in such a manner that they are located in immediate proximity to the respective one of the electrodes.

Another advantage of the present invention is that the device in accordance with the invention and the method permit to control the various partial processes which have been described as taking place at the various electrodes, with the possibility of measuring certain voltages (potentials) concurrently. This provision permits to locate problems in current transfer.

The invention will be described in closer detail with reference to the following figures in which:
- **Fig. 1**: is a schematic cross section of a structure (trench, via) in a dielectric on a semiconductor substrate,
- **Fig. 2**: is a schematic representation of the potential differences in an anode and cathode arrangement with a respective reference electrode being provided in proximity to the anode and in proximity to the cathode,
- **Fig. 3**: is a schematic sectional view of a deposition cell,
- **Fig. 4**: is a schematic view of a deposition cell for problem analysis of current fluctuations during deposition.

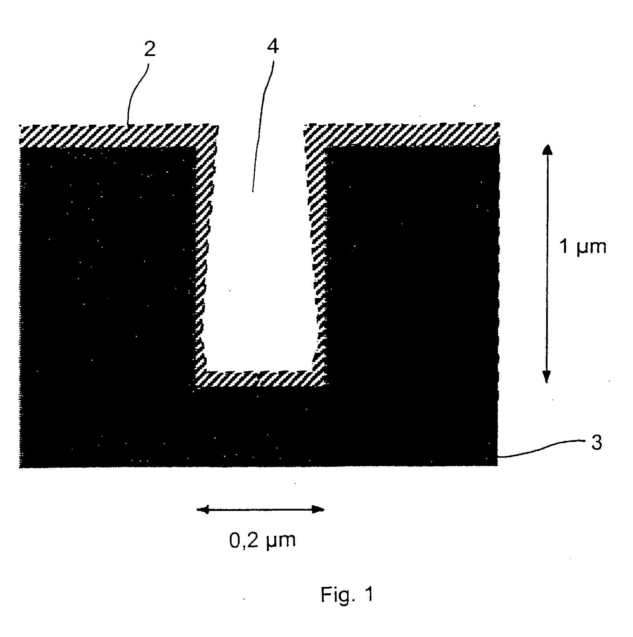

**Fig. 1** shows the coating thickness distribution of the starting layer **2** in proximity to and within a structure **4** in a dielectric layer **3** on a semiconductor substrate. In the present case, the structure **4** is 0.2 µm wide and about 1 µm deep. At the surface of the substrate, the starting layer **2** is approximately 100 nm thick. The starting layer **2** is much thinner at the bottom of the structure **4,** though. There, it is only 5 - 25 nm thick. In this lower region, there is the risk that the layer **2** is removed to such an extent during immersion and subsequent wetting of the starting layer **2** with a metal deposition electrolyte that no metal or but a very thin layer thereof is left at the bottom of the structure **4.** As a result, no metal can be deposited onto this site during the subsequent electrolytic metal plating process.

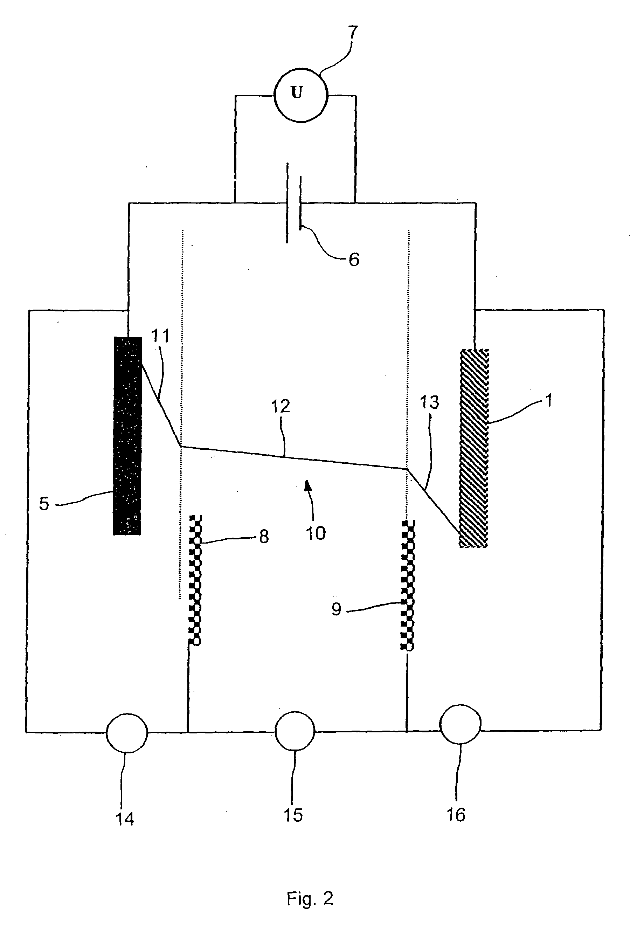

**Fig. 2** is a schematic illustration of the potential difference between the anode **5** and the cathode **1** in the space containing the electrolyte. Current delivered by a current supply **6** flows between anode **5** and cathode **1.** The current supply **6** may be a power rectifier for example. The voltage **U** delivered by the current supply **6** is measured using a voltmeter **7.** The voltage **U** is also termed clamp voltage.

In proximity to the anode **5** there is disposed a first reference electrode **8.** Likewise, a second reference electrode **9** is disposed in proximity to the cathode **1.**

The potential difference in the space containing the electrolyte between the anode **5** and the cathode **1** is labeled with the numeral **10.** For simplification sake, the potential difference **10** is divided in only three portions **11, 12** and **13,** the portions **11** and **13** being generated by the diffusion and crystallization overvoltages and portion **12** arising from the voltage drop generated by the electric resistance of the electrolyte.

The voltage drops mentioned can be determined in a simple manner by measuring the electric voltages between the anode **5** and the first reference electrode **8** using the first voltmeter **14,** between the first reference electrode **8** and the second reference electrode **9** using the second voltmeter **15** and between the second reference electrode **9** and the cathode **1** using the third voltmeter **16.** The sum of the partial voltages **11, 12, 13** as measured by the voltmeters **14, 15** and **16** yields the clamp voltage **U.**

The voltage drop **11** is measured by voltmeter **14,** the voltage drop **12** by voltmeter **15** and the voltage drop **13** by voltmeter **16.**

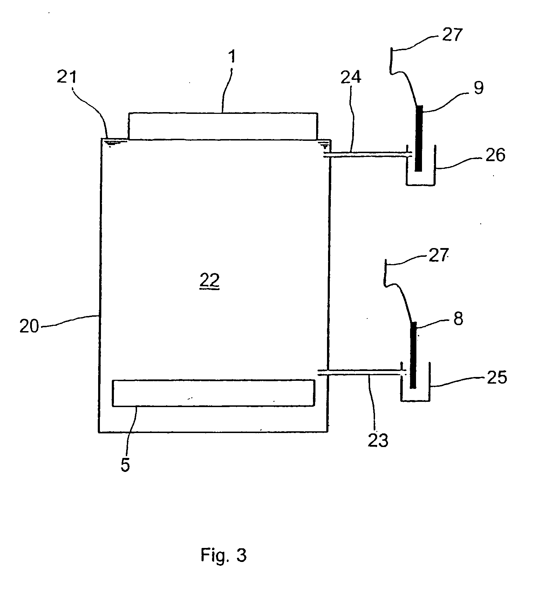

**Fig. 3** is a schematic illustration of an arrangement for electrolytically depositing metal on a semiconductor substrate **1.** The arrangement has a tank **20** and an anode **5** on the bottom of the tank **20** and a semiconductor substrate **1** employed as a cathode in the upper portion of the tank **20.** The tank **20** is filled with electrolyte fluid **22** to level **21.** Fluid **22** can for example enter the tank **20** from the bottom and flow through the anode **5.** The anode **5** is preferably perforated for this purpose.

In the wall of tank **20,** a first capillary **23** is embedded in proximity to the anode **5** and a second capillary **24** in proximity to the semiconductor substrate **1.** Electrolyte fluid can flow in a small volume flow through said capillaries **23, 24** into the reference electrode containers **25** and **26** mounted to the sides thereof. This prevents electrolyte fluid, which may be contained in said containers **25, 26** and has another formulation than the deposition fluid **22,** from entering tank **20.** The containers **25, 26** accommodate a first reference electrode **8** and a second reference electrode **9** that are connected through electrical lines to voltmeters (not shown).

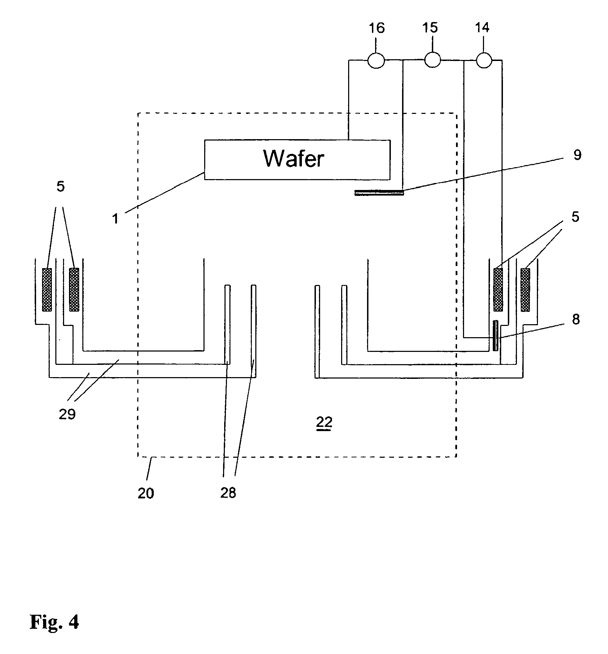

**Fig. 4** is a schematic illustration of a deposition cell. The anodes **5** are formed by an inert anode basket which is surrounded by a diaphragm (not shown herein) and holds the metal to be deposited, e.g., in the form of shot or pellets. The anodes **5** are located outside tank **20.** They are coupled through conduits **29** that are coupled into tank **20** by way of shields **28.** The shields **28** act as virtual anodes. A first reference electrode **8** is disposed in proximity to the anodes **5.** A second reference electrode **9** is likewise disposed in proximity to the cathode **1.** The electric voltages between the cathode **1** and the second reference electrode **9,** between the second reference electrode **9** and the first reference electrode **8** and between the first reference electrode **8** and the anodes **5** are measured using the voltmeters **16, 15, 14,** respectively. The tank **20** is completely filled with electrolyte fluid **22.**

A test performed in practical operation showed that the amount of metal deposited onto the cathode **1** was not sufficient. Concurrently, although the voltage applied was 20 V, a very low current of about 100 mA only was measured between the cathode **1** and the anodes **5** as compared to usual deposition cells (10 A at only 2 - 3 V). The reasons therefore could have been for example:
1. insufficient electric contact between the cathode **1** and the electrolyte fluid **22,**
2. disruption of the conduits **29,**
3. insuffient electric contact between the anodes **5** and the electrolyte fluid **22** or
4. deficient electrolyte flow through the conduits **29.**

In designing the measuring device in accordance with the invention, which is comprised here of the two reference electrodes **8, 9** and the voltmeters **14, 15,** 16, the following results could be obtained simultaneously in accordance with the invention so that fault finding was made possible:

Between the cathode **1** and the second reference electrode **9** a voltage of about 0.5 V that was stable over time was measured using the voltmeter **16.** The voltage between the two reference electrodes **8, 9** as measured by voltmeter **15** was 1 V and stable over time. By contrast, the voltage between the first reference electrode **8** and the anode **5** was approximately 18.5 V and varied in time with the overall voltage.

These results permitted to dismiss the afore mentioned reasons 1, 2 and 4. The problem could be eliminated by improving the electrical contact established at the transition between the anodes **5** and the electrolyte fluid **22.** It was found out that the diaphragm disposed around the anode basket was no longer wetted in the electrolyte fluid.

In a further example an electrolytic copper bath **22** was used to deposit a copper layer on a semiconductor wafer **1.** The wafer **1** was provided with a copper seed layer which was aproximately 100 nm thick. The copper seed layer was coated with a photoresist layer having vias and trenches exposing the copper seed layer. The copper bath **22** contained copper sulfate, sulfuric acid and a minor amount of sodium chloride as well as generic additive components that are usually used to optimize physico-mechanical properties. The bath **22** was operated in a deposition tank **20** with a design of the tank as shown in **Fig. 4****.** The anode **5** was insoluble, being made from an expanded metal sheet of titanium, which was activated with noble metal (e.g. platinum). In order to maintain a nominal copper ion concentration in the bath **22** copper pieces were dissolved in a separate container (not shown herein) which was in fluid connection with the tank **20.** In order to promote copper dissolution the bath **22** also contained Fe(II) and Fe(III) compounds. A bath suitable for this purpose is described in DE 199 15 146 C1 for example.

After the wafer **1** had been brought into contact with the copper bath **22** and after a certain idle time thereafter, current was switched on to have the wafer **1** be metallized. Prior to switching the current on the copper seed layer risked to be etched by the copper plating bath **22** or, more specifically, by the Fe(III) ion compounds in this bath **22.** For this reason electroplating was a problem if the copper seed layer at least partially dissolved prior to first copper deposition.

Electroplating was effected by an electrolytic current flowing between the wafer **1** and the anode **5.** Safe initiation of copper deposition could easily be determined by measuring the voltage between the wafer **1** and the reference electrode **9** over time in order to ascertain whether safe wetting of the wafer **1** occurred and whether a sufficiently thick copper seed layer was still present at the surface of the wafer **1.** If the voltage was not determined to be in the value range expected, deficient electroplating was expected.

Furthermore the voltage between the wafer **1** and the reference electrode **9** was measured. Practicing this measurement during the entire electroplating process a defined potential control of the wafer **1** was achieved. This also guaranteed process safety during the entire copper plating process including the method steps of immersion and wetting of the wafer **1.** It turned out that seed layer etching could be prevented if a suitable voltage was applied to the wafer **1.** Under these conditions the wetting period of the wafer **1** could be optimized, i.e. extended.

At the same time processing was also found to be influenced by imponderable conditions at the anode **5.** It turned out that too high a plating rate would lead to a material transport in the plating bath **22** being rate determining (reaction of Fe(II) to Fe(III)). This could lead to water electrolysis and hence generation of oxygen gas bubbles at the anode **5.** At the same time the anode potential was measured to shift. Under unfavourable conditions this shift was detected by measuring the voltage between the anode **5** and the reference electrode **8.** Therefore by ascertaining a voltage which was outside the normal range the processing parameters could be suitably adjusted in order to prevent deficient processing.

Hence, it turned out that processing deficiencies, which were caused by deficient anodic and/or cathodic processes, could be detected, if the voltages mentioned and the clamp voltage deviated from the normal ranges. Only by simultaneously measuring these voltages as well as the clamp voltage between the wafer **1** and the anode **5,** the causes for the deficiencies could be found out.

### Listing of numerals:

- **1**: semiconductor substrate (cathode)
- **2**: starting layer (seed layer, plating base)
- **3**: dielectric layer
- **4**: structure in the dielectric layer **3**
- **5**: anode
- **6**: current supply (voltage source)
- **7**: voltmeter for the clamp voltage **U**
- **8**: first reference electrode
- **9**: second reference electrode
- **10**: potential difference
- **11**: voltage drop at the anode **5**
- **12**: voltage drop in the electrolyte **22**
- **13**: voltage drop at the cathode **1**
- **14, 15, 16**: voltmeters
- **20**: tank
- **21**: fluid level
- **22**: electrolyte fluid
- **23, 24**: capillaries
- **25, 26**: reference electrode containers
- **27**: electrical lines
- **28**: shields (virtual anode)
- **29**: conduit
- **U**: clamp voltage

## Claims

1. A device for monitoring an electrolytic process, comprising at least one anode and at least one cathode, at least one first reference electrode being brought so close to the surface of the at least one anode and at least one second reference electrode being brought so close to the surface of the at least one cathode that the respective one of the potentials can be measured directly, at least one voltmeter being respectively provided for measuring the electric voltages between the at least one anode and the at least one first reference electrode, between the at least one first and the at least one second reference electrode and between the at least one second reference electrode and the at least one cathode, wherein the cathode is a wafer or a chip carrier substrate.

2. The device according to claim 1, wherein the at least one reference electrode communicates through capillaries with the surface of the at least one anode or with the surface of the at least one cathode.

3. The device according to claim 2, wherein means are provided by means of which electrolyte fluid is deliverable through the capillaries to the at least one reference electrode.

4. The device according to one of the aforementioned claims, wherein the at least one anode and the at least one cathode are paralleled and oriented horizontally or tilted from horizontal.

5. The device according to one of the aforementioned claims, wherein the anode is a metal plate.

6. A method of monitoring an electrolytic process in an electrolytic cell comprised of at least one anode and of at least one cathode, at least one first reference electrode being brought so close to the surface of the at least one anode and at least one second reference electrode being brought so close to the surface of the at least one cathode that the respective one of the potentials can be measured directly, at least one voltmeter being respectively provided for measuring the electric voltages between the at least one anode and the at least one first reference electrode, between the at least one first and the at least one second reference electrode and between the at least one second reference electrode and the at least one cathode, wherein the cathode is a wafer or a chip carrier substrate,
said method involving the following method steps:
a) providing an electric current flow between the at least one anode and the at least one cathode,
b) concurrently measuring the respective electric voltages between
b1) the at least one anode and the at least one first reference electrode,
b2) between the at least one first and the at least one second reference electrode and
b3) between the at least one second reference electrode and the at least one cathode.

7. The method according to claim 6, wherein the at least one reference electrodes are brought into contact with the surface of the at least one anode or with the surface of the at least one cathode by way of capillaries.

8. The method according to claim 7, wherein electrolyte fluid is delivered through the capillaries to the at least one reference electrodes.

9. The method according to one of the claims 6 - 8, wherein the at least one anode and the at least one cathode are paralleled and oriented horizontally or tilted from horizontal.

10. The method according to one of the claims 6 - 9, wherein the anode is a metal plate and wherein the metal is electrolytically deposited on the wafer or chip carrier substrate.

## Patentansprüche

1. Vorrichtung zur Überwachung eines elektrolytischen Prozesses, umfassend mindestens eine Anode und mindestens eine Kathode, wobei mindestens eine erste Bezugselektrode so dicht an die Oberfläche der mindestens einen Anode und mindestens eine zweite Bezugselektrode so dicht an die Oberfläche der mindestens einen Kathode gebracht ist, dass das jeweilige Potential direkt messbar ist, wobei jeweils mindestens ein Spannungsmessgerät zur Ermittlung der elektrischen Spannungen zwischen der mindestens einen Anode und der mindestens einen ersten Bezugselektrode, zwischen der mindestens einen ersten und der mindestens einen zweiten Bezugselektrode und zwischen der mindestens einen zweiten Bezugselektrode und der mindestens einen Kathode vorgesehen ist, wobei die Kathode ein Wafer oder ein Chipträger-Substrat ist.

2. Vorrichtung nach Anspruch 1, wobei die mindestens eine Bezugselektrode über Kapillaren mit der Oberfläche der mindestens einen Anode oder mit der Oberfläche der mindestens einen Kathode in Verbindung steht.

3. Vorrichtung nach Anspruch 2, wobei Mittel vorgesehen sind, mit denen Elektrolytflüssigkeit durch die Kapillaren zu der mindestens einen Bezugselektrode förderbar ist.

4. Vorrichtung nach einem der vorstehenden Ansprüche, wobei die mindestens eine Anode und die mindestens eine Kathode parallel zueinander und waagerecht oder zur Horizontalen gekippt ausgerichtet sind.

5. Vorrichtung nach einem der vorstehenden Ansprüche, wobei die Anode eine Metallplatte ist.

6. Verfahren zur Überwachung eines elektrolytischen Prozesses in einer elektrolytischen Zelle, die umfasst: mindestens eine Anode und mindestens eine Kathode, mindestens eine erste Bezugselektrode, die so dicht an die Oberfläche der mindestens einen Anode gebracht ist, und mindestens eine zweite Bezugselektrode, die so dicht an die Oberfläche der mindestens einen Kathode gebracht ist, dass das jeweilige Potential direkt messbar ist, wobei jeweils mindestens ein Spannungsmessgerät zum Messen der elektrischen Spannungen zwischen der mindestens einen Anode und der mindestens einen ersten Bezugselektrode, zwischen der mindestens einen ersten und der mindestens einen zweiten Bezugselektrode und zwischen der mindestens einen zweiten Bezugselektrode und der mindestens einen Kathode vorgesehen ist, wobei die Kathode ein Wafer oder ein Chipträger-Substrat ist, und wobei das Verfahren folgende Verfahrensschritte umfasst:
a) Vorsehen eines elektrischen Stromflusses zwischen der mindestens einen Anode und der mindestens einen Kathode,
b) gleichzeitig Messen der jeweiligen elektrischen Spannungen zwischen
b1) der mindestens einen Anode und der mindestens einen ersten Bezugselektrode,
b2) zwischen der mindestens einen ersten und der mindestens zweiten Bezugselektrode und
b3) zwischen der mindestens einen zweiten Bezugselektrode und der mindestens einen Kathode.

7. Verfahren nach Anspruch 6, wobei die mindestens eine Bezugselektrode über Kapillaren mit der Oberfläche der mindestens einen Anode oder mit der Oberfläche der mindestens einen Kathode in Kontakt gebracht wird.

8. Verfahren nach Anspruch 7, wobei Elektrolytflüssigkeit durch die Kapillaren zu der mindestens einen Bezugselektrode gefördert wird.

9. Verfahren nach einem der Ansprüche 6 - 8, wobei die mindestens eine Anode und die mindestens eine Kathode parallel zueinander und waagerecht oder zur Horizontalen gekippt ausgerichtet werden.

10. Verfahren nach einem der Ansprüche 6 - 9, wobei die Anode eine metallische Platte ist und auf dem Wafer oder dem Chipträger-Substrat Metall elektrolytisch abgeschieden wird.

## Revendications

1. Dispositif de contrôle d'un processus électrolytique, comprenant au moins une anode et au moins une cathode, au moins une première électrode de référence étant amenée si près de la surface de l'au moins une anode et l'au moins une seconde électrode de référence étant amenée si près de la surface de l'au moins une cathode que le potentiel respectif des potentiels peut être mesuré directement, au moins un voltmètre étant prévu respectivement pour mesurer les tensions électriques entre l'au moins une anode et l'au moins une première électrode de référence, entre l'au moins une première et l'au moins une seconde électrode de référence et entre l'au moins une seconde électrode de référence et l'au moins une cathode, la cathode étant une tranche ou un substrat porte-puce.

2. Dispositif selon la revendication 1, dans lequel l'au moins une électrode de référence communique par le biais de capillaires avec la surface de l'au moins une anode ou avec la surface de l'au moins une cathode.

3. Dispositif selon la revendication 2, dans lequel des moyens sont prévus pour permettre au fluide électrolytique d'être délivré par le biais des capillaires à l'au moins une électrode de référence.

4. Dispositif selon une des revendications susmentionnées, dans lequel l'au moins une anode et l'au moins une cathode sont parallèles et orientées horizontalement ou inclinées par rapport à l'horizontale.

5. Dispositif selon une des revendications susmentionnées, dans lequel l'anode est une plaque métallique.

6. Procédé de contrôle d'un processus électrolytique dans une cellule électrolytique composée d'au moins une anode et d'au moins une cathode, au moins une première électrode de référence étant amenée si près de la surface de l'au moins une anode et au moins une seconde électrode de référence étant amenée si près de la surface de l'au moins une cathode que le potentiel respectif des potentiels peut être mesuré directement, au moins un voltmètre étant respectivement prévu pour mesurer les tensions électriques entre l'au moins une anode et l'au moins une première électrode de référence, entre l'au moins une première et l'au moins une seconde électrode de référence et entre l'au moins une seconde électrode de référence et l'au moins une cathode, la cathode étant une tranche ou un substrat porte-puce,
ledit procédé impliquant les étapes de procédé comprenant :
a) fournir un flux de courant électrique entre l'au moins une anode et l'au moins une cathode,
b) mesurer parallèlement les tensions électriques respectives entre
b1) l'au moins une anode et l'au moins une première électrode de référence,
b2) entre l'au moins une première et l'au moins une seconde électrode de référence et
b3) entre l'au moins une seconde électrode de référence et l'au moins une cathode.

7. Procédé selon la revendication 6, dans lequel l'au moins une des électrodes de référence est amenée en contact avec la surface de l'au moins une anode ou avec la surface de l'au moins une cathode par le biais de capillaires.

8. Procédé selon la revendication 7, dans lequel le fluide électrolytique est délivré par le biais des capillaires à l'au moins une des électrodes de référence.

9. Procédé selon une des revendications 6 à 8, dans lequel l'au moins une anode et l'au moins une cathode sont parallèles et orientées horizontalement ou inclinées par rapport à l'horizontale.

10. Procédé selon une des revendications 6 à 9, dans lequel l'anode est une plaque métallique et dans lequel le métal est déposé électrolytiquement sur la tranche ou le substrat porte-puce.
